(19) Europäisches Patentamt
European Patent Office
Office européen des brevets

(11) **EP 2 405 574 B1**

(12) **FASCICULE DE BREVET EUROPEEN**

(45) Date de publication et mention
de la délivrance du brevet:
**05.09.2018 Bulletin 2018/36**

(51) Int Cl.:
*H03H 9/02* (2006.01)

(21) Numéro de dépôt: **11171504.1**

(22) Date de dépôt: **27.06.2011**

(54) **Dispositif d'adaptation d'impédance d'un composant comportant un filtre a impédance adaptable à base de matériau de type perovskite**

Vorrichtung zur Adaptation der Impedanz einer Komponente, die einen adaptierbaren Impedanzfilter auf der Basis eines Materials vom Typ Perowskit umfasst

Device for adapting the impedance of a component comprising a filter with adaptable impedance made of a material such as perovskite

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.07.2010 FR 1055450**

(43) Date de publication de la demande:
**11.01.2012 Bulletin 2012/02**

(73) Titulaire: **COMMISSARIAT À L'ÉNERGIE ATOMIQUE ET AUX ÉNERGIES ALTERNATIVES**
**75015 Paris (FR)**

(72) Inventeurs:
• **David, Jean-Baptiste**
  **38000 GRENOBLE (FR)**
• **Billard, Christophe**
  **38140 RENAGE (FR)**
• **Defay, Emmanuel**
  **38340 VOREPPE (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arcueil Cedex (FR)**

(56) Documents cités:
**US-A1- 2007 210 879    US-A1- 2009 066 440**

• **PAVEL A TURALCHUK ET AL: "Modelling of tunable bulk acoustic resonators and filters with induced piezoelectric effect in BSTO film in a wide temperature range", EUROCON 2009, EUROCON '09. IEEE, IEEE, PISCATAWAY, NJ, USA, 18 mai 2009 (2009-05-18), pages 64-69, XP031491823, ISBN: 978-1-4244-3860-0**
• **NOETH A ET AL: "Tunable thin film bulk acoustic wave resonator based on BaxSr1xTiO3 thin film", IEEE TRANSACTIONS ON ULTRASONICS, FERROELECTRICS AND FREQUENCY CONTROL, IEEE, US, vol. 57, no. 2, 1 février 2010 (2010-02-01), pages 379-385, XP011303273, ISSN: 0885-3010**
• **WAI CHAN ET AL: "A fast and accurate automatic matching network designed for ultra low power medical applications", CIRCUITS AND SYSTEMS, 2009. ISCAS 2009. IEEE INTERNATIONAL SYMPOSIUM ON, IEEE, PISCATAWAY, NJ, USA, 24 mai 2009 (2009-05-24), pages 673-676, XP031479280, ISBN: 978-1-4244-3827-3**

EP 2 405 574 B1

**Description**

Le domaine de l'invention est celui des dispositifs d'adaptation d'impédance particulièrement intéressants en tant que suiveur d'impédance de composant et notamment d'antenne dans les chaînes d'émission ou de réception de circuit radiofréquence, confronté à des variations d'impédance.

Actuellement, les besoins en matière d'agilité se font de plus en plus pressants, en raison notamment de l'encombrement croissant du spectre électromagnétique, de l'augmentation systématique des débits demandés, et de la reconfigurabilité logicielle des terminaux mobiles.

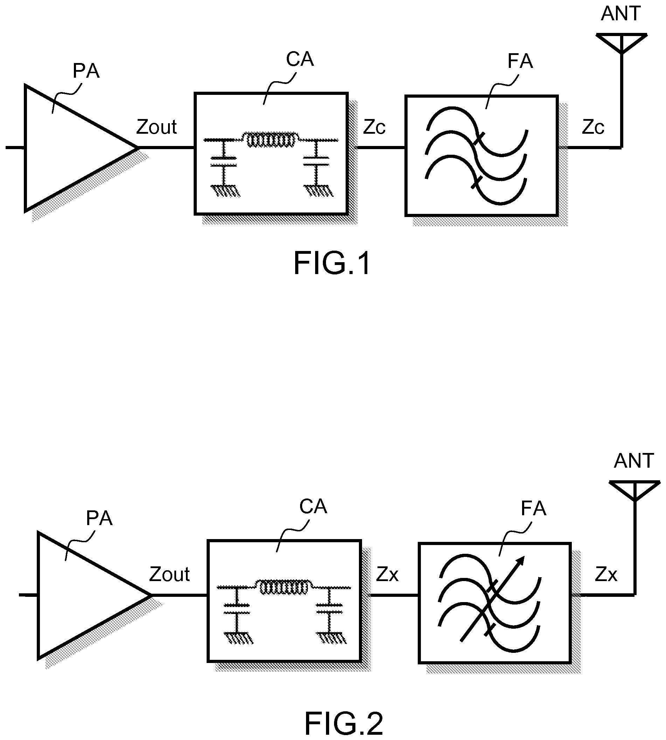

De manière générale, une chaine d'émission RF telle qu'illustrée en figure 1, comporte trois bloc principaux entre par exemple, la génération d'un signal radio en forte puissance, et l'antenne.

Ces trois blocs sont l'amplificateur de puissance PA, le circuit d'adaptation CA en sortie d'amplificateur, qui assure le transfert de l'énergie de l'amplificateur vers l'antenne, et le filtre d'antenne FA, qui assure la pureté spectrale du signal émis par le système vers l'antenne ANT.

Les amplificateurs, les filtres et les antennes étant réalisés par des fournisseurs souvent différents, les composants doivent donc pouvoir être fonctionnels à une impédance caractéristique Zc donnée.

Avec la miniaturisation poussée dans la téléphonie mobile, l'optimisation conduit les constructeurs d'antennes à vouloir se libérer de la contrainte d'impédance standard. Il en résulte, pour les concepteurs de systèmes, soit la nécessité d'ajouter un circuit d'adaptation en sortie de filtre, soit de disposer de filtres dont l'impédance Zx est adaptée à l'impédance propre de l'antenne, tendant à implémenter ainsi le schéma tel qu'illustré en figure 2.

La prise en charge de ces comportements dynamiques assure non seulement un gain à court terme sur la consommation en énergie des systèmes actuels, mais elle permet aussi de mettre en oeuvre certains systèmes innovants par leur reconfigurabilité.

Plusieurs approches élaborées jusqu'à présent sont décrites dans la littérature et notamment dans l'article suivant : "An Automatic Antenna Tuning System using only RF-Signal Amplitudes", E.L. Firrao, A.J. Annema, and B. Nauta, IEEE TCAS-II, 2008.

Les auteurs, de l'université de Twente et de Thales, proposent une adaptation dynamique d'antenne en corrélation avec le concept de l'adaptation par réglage séparé de la partie réelle et de la partie imaginaire.

Après que le système ait obtenu une information sur la désadaptation de l'antenne vis-à-vis de la chaine RF, des éléments réglables dynamiquement permettent le déplacement du lieu d'impédance de l'antenne. L'impédance est adaptée après un temps de convergence. Le principe a été démontré pour un signal à 900MHz, et des cas discrets d'impédances. Cependant la robustesse face à une large bande de fréquence, et pour des vastes lieux d'impédances reste à démontrer.

D'autres auteurs comprenant une équipe du CEA ont développé une approche sensiblement différente, en collaboration avec l'université de Bordeaux et le groupe Sorin, spécialisé notamment dans la mise au point de pacemakers dans l'article "A fast and accurate automatic matching network designed for ultra low power medical applications", Wai Chan; De Foucauld, E.; Vincent, P.; Hameau, F.; Morche, D.; Delaveaud, C.; Dal Molin, R.; Pons, P.; Pierquin, R.; Kerherve, E.; Circuits and Systems, 2009. IEEE ISCAS 2009.

Un circuit d'adaptation contenant plusieurs éléments variables est piloté par un microcontrôleur ou processeur dont le rôle est de spécifier les consignes de réglage en fonction de l'analyse d'un signal prélevé à travers un atténuateur.

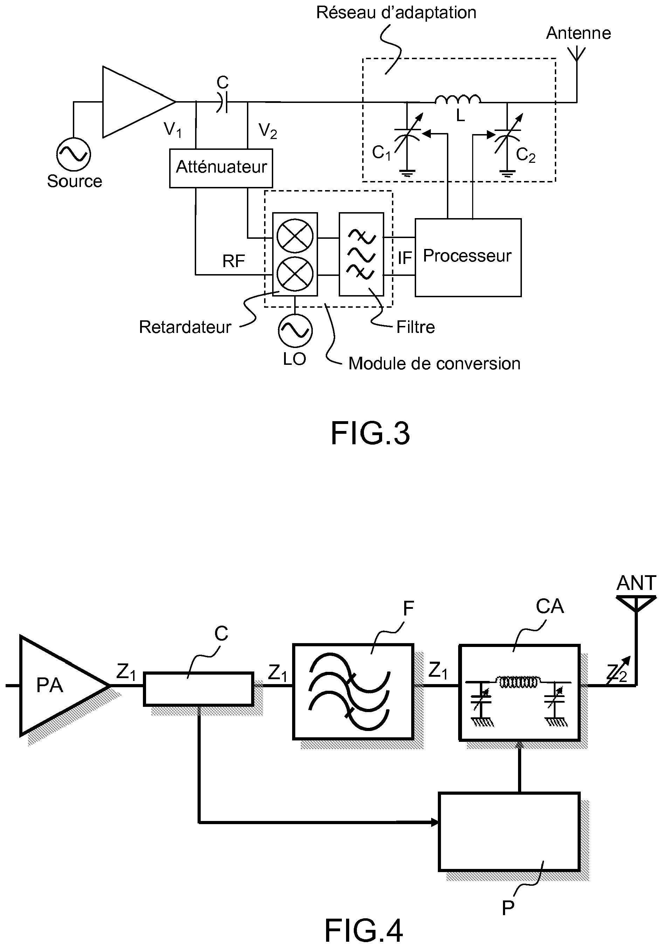

La démonstration de l'approche a été réalisée autour de la bande ISM 402-405MHz, et suppose un temps de traitement de presque 1ms. La figure 3 illustre l'auto-adaptation d'impédance d'antenne à 400MHz par microcontrôleur.

Des résultats comparables ont été publiés par la même équipe pour la bande ISM 2.4GHz dans l'article suivant :"A 2.4GHz CMOS automatic matching network design for pacemaker applications", Chan Wai Po F; De Foucauld, E.; Vincent, P.; Hameau, F.; Kerherve, E.; Molin R, D.; Pons, P.; Pierquin, R.; Circuits and Systems and TAISA Conference, 2009.

Si le principe théorique de l'adaptation directe par microcontrôleur est démontré, et a fait l'objet d'un brevet déposé par le CEA (EP2037576), sa mise en oeuvre demeure complexe, et limitée par l'implémentation physique. Ainsi, la couverture en impédance dépend de la complexité du circuit d'adaptation, et notamment du nombre d'éléments réglables, ainsi que de leur nature (inductance ou condensateur). D'autre part, cette approche qui a le mérite d'être directe (et non itérative) donc susceptible d'être rapide, nécessite de pouvoir déterminer analytiquement la valeur des éléments de réglage. La détermination analytique est aisément implémentable au sein du microcontrôleur. Cependant la complexité de l'implémentation augmente avec le nombre d'éléments variables, ainsi qu'avec la présence d'éléments filtrants entre l'amplificateur et l'antenne.

La performance de cette approche dépend du nombre d'éléments accordables disponibles, de leur plage de variation, de leur qualité, ainsi que du champ de dispersion en impédance de l'antenne.

Ainsi, si un filtre après amplification est nécessaire, le schéma illustré en figure 4 devient applicable. Un capteur C est positionné en sortie de l'amplificateur et présente une impédance d'entrée et une impédance de sortie Z1, la chaîne comporte en outre le filtre F et un circuit d'adaptation CA, un processeur P est prévu pour influer sur le circuit d'impédance et adapter ce dernier aux variations d'impédance de l'antenne ANT.

L'adaptation a lieu après le filtre, qui doit alors présenter une impédance caractéristique identique à l'impédance de sortie de l'amplificateur de puissance. Rappelons que le filtre est un élément réciproque, c'est-à-dire qu'il présente la même impédance en entrée et en sortie.

Dans le but de relâcher les contraintes sur le circuit d'adaptation ajustable, et accroître le champ d'application de la méthode décrite ici, le demandeur propose un dispositif d'adaptation d'impédance de composant particulièrement simple et rapide permettant de disposer de filtres agiles en impédance ayant des temps d'adaptation extrêmement brefs et ce en utilisant des matériaux dont la permittivité diélectrique peut être adaptée rapidement.

Plus précisément la présente invention a pour objet un dispositif comprenant en entrée un premier composant de première impédance de sortie, en sortie un second composant de seconde impédance d'entrée , un circuit d'adaptation d'impédance entre lesdits premier et second composants caractérisé en ce que la première et/ou la deuxième impédance étant variable, ledit circuit d'adaptation d'impédance comprend un filtre à impédance adaptable aux première et seconde impédances, situé entre lesdits premier et second composants et comprenant au moins deux résonateurs couplés à ondes acoustiques, au moins un des résonateurs comportant un matériau de type pérovskite et des moyens pour appliquer une tension audit résonateur permettant d'en faire varier la permittivité et l'impédance, lesdits moyens pour appliquer une tension étant réglés sur une plage de tension pour laquelle la bande de fréquence dudit filtre à adaptation d'impédance varie de peu, typiquement de quelques pourcents, la variation de l'impédance d'au moins ledit résonateur générant l'adaptation de l'impédance dudit filtre. Selon une variante de l'invention, chaque résonateur comprend un matériau de type pérovskite.

Selon une variante de l'invention, le filtre comporte des résonateurs à ondes de volume.

Selon une variante de l'invention, le filtre comporte des résonateurs à ondes de volume de type FBAR comportant un empilement de couches comprenant au moins une membrane de support et une couche de matériau de type pérovskite.

Selon une variante de l'invention, le filtre comporte des résonateurs à ondes de volume de type SMR comprenant au moins un réflecteur acoustique et une couche de matériau de type pérovskite.

Selon une variante de l'invention, le matériau de type pérovskite est à base de Baryum-Strontium-Titanate (BST).

Selon une variante de l'invention, le filtre comporte un ensemble de résonateurs montés en structure échelle et/ou en structure treillis.

Selon une variante de l'invention, ledit circuit d'adaptation d'impédance comprend en outre d'autres éléments d'impédance.

Selon une variante de l'invention, le composant à impédance variable est une antenne et peut être le premier ou le second composants.

Selon une variante de l'invention, le composant à impédance variable est un amplificateur et peut être le premier et/ou le second composants.

Selon une variante de l'invention, le composant à impédance variable est un transistor et peut être le premier et/ou le second composants .

Selon une variante de l'invention, le dispositif est inclus dans une chaîne d'émission et/ou de réception radiofréquence dans laquelle le premier composant est un amplificateur, le second composant étant une antenne.

Le circuit d'adaptation d'impédance peut en outre comporter en plus du filtre des éléments complémentaires (généralement en série) tels que des inductances et/ou des condensateurs pour accroître la plage de variation d'impédances possible du dispositif.

L'invention sera mieux comprise et d'autres avantages apparaîtront à la lecture de la description qui va suivre donnée à titre non limitatif et grâce aux figures annexées parmi lesquelles :

- la figure 1 illustre une chaîne d'émission RF comprenant un filtre, selon l'art connu ;
- la figure 2 illustre une chaîne d'émission RF comprenant un filtre avec une impédance adaptable à celle de l'antenne selon l'art connu ;
- la figure 3 illustre une solution d'auto-adaptation d'impédance d'antenne selon l'art antérieur ;
- la figure 4 illustre le schéma de l'adaptation dynamique d'impédance avec filtre d'émission ;
- la figure 5 illustre l'évolution de la déformation sous l'effet d'un champ électrique dans un matériau piézoélectrique classique et dans un matériau électrostrictif ;
- la figure 6 illustre la variation d'impédance en fonction de la fréquence et ce pour différentes tensions appliquées sur une couche de BST de 580 nm d'épaisseur en présence d'électrodes de Platine de 200 nm ;
- la figure 7 illustre la modélisation électromécanique d'un matériau passif et d'un matériau piézo-électrique ;
- la figure 8 illustre l'évolution de la permittivité en fonction de la tension DC appliquée pour un résonateur à ondes de volume à base de BST dans un modèle de type Mason ;
- la figure 9 illustre l'évolution de l'impédance équivalente en fonction de la tension DC appliquée pour un résonateur à ondes de volume à base de BST;

- la figure 10 illustre l'évolution du coefficient de couplage en fonction de la tension DC appliquée pour un résonateur à ondes de volume à base de BST ;
- la figure 11 illustre l'évolution des coefficients de qualité Qs et Qp respectivement aux fréquences de résonances dites série et parallèle en fonction de la tension DC appliquée pour un résonateur à ondes de volume à base de BST ;
- la figure 12 illustre l'évolution des fréquences de résonance dites série et parallèle en fonction de la tension DC appliquée pour un résonateur à ondes de volume à base de BST ;
- les figures 13a, 13b et 13c illustrent l'évolution de la puissance transmise et des pertes au niveau d'un filtre à base de BST utilisé dans la présente invention et dans une première gamme de tensions appliquées ;
- les figures 14a, 14b et 14c illustrent l'évolution de la puissance transmise et des pertes au niveau d'un filtre à base de BST utilisé dans la présente invention et dans une seconde gamme de tensions appliquées ;
- la figure 15 illustre un schéma de dispositif d'adaptation d'impédance selon l'invention ;
- la figure 16 illustre un exemple de filtre adaptable en impédance selon l'invention comprenant huit résonateurs de type BAW et dans une structure de type « Double Lattice » ;
- la figure 17 illustre une coupe transversale d'un exemple d'empilement technologique permettant la réalisation d'un résonateur de type FBAR dans un filtre adaptable utilisé dans la présente invention ;
- la figure 18 illustre une vue de dessus d'un exemple d'implantation de filtre adaptable en impédance et utilisé dans la présente invention.

Selon la présente invention, il est proposé de réaliser un filtre adaptable en impédance à partir de résonateurs comportant un matériau de type pérovskite et tel qu'il dispose d'une grande latitude de variation de constante diélectrique sous l'action d'une variation de champ électrique appliqué. Ce type de matériau présente en effet des constantes diélectriques élevées et susceptibles de pouvoir varier fortement sous l'action d'un champ électrique.

L'invention va être décrite ci-après dans le cadre de résonateurs à ondes de volume, mais peut néanmoins tout aussi bien être mise en oeuvre avec des filtres à ondes de surface ou à ondes de Lamb, lesdits filtres comportant un matériau de type pérovskite présentant des propriétés telles que l'impédance de chaque résonateur peut être modifiée à l'aide d'une tension continue appliquée à ses bornes.

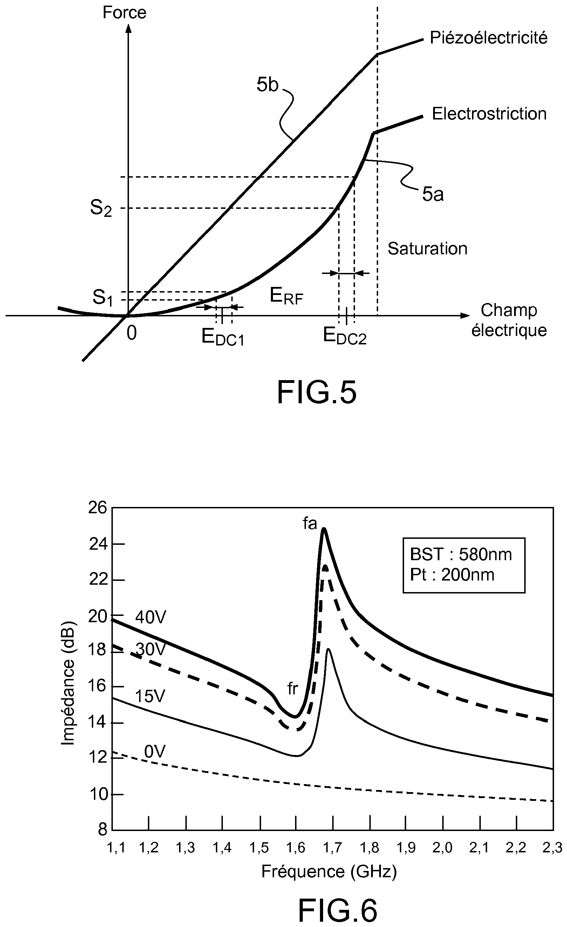

L'intérêt des matériaux de type pérovskite et notamment au plomb $Pb(Mg_{1/3}Nb_{2/3})O_3$ (PMN) est illustré en figure 5.

De manière générale, ces matériaux sont des matériaux d'organisation cristalline telle qu'ils présentent des propriétés électrostrictives très prononcées, qui se traduisent notamment par la présence d'un coefficient de couplage piézoélectrique dépendant d'une tension continue appliquée. Ainsi, le matériau pérovskite présente une pente qui varie selon la valeur du champ électrique comme illustré sur la courbe 5a de la figure 5, contrairement à un matériau piézoélectrique classique, dont le coefficient de couplage reste constant quelque soit le champ électrique appliqué comme illustré par la courbe 5b.

En effet l'intérêt des matériaux de type pérovskite réside dans la non-linéarité de l'évolution de la déformation sous l'effet d'un champ électrique en comparaison avec les matériaux piézoélectriques classiques, permettant avec de tels matériaux, d'obtenir une grande sensibilité en terme de variation de permittivité électrique $\varepsilon$ et donc d'impédance en fonction d'un champ électrique appliqué.

La variation des propriétés physiques des matériaux sous l'effet d'un champ électrique $E_{dc}$ (que l'on connait sous le terme d'électrostriction) notamment de la permittivité $\varepsilon$, de la raideur $c$ et du facteur de couplage piézoélectrique $h$, se traduit par les équations suivantes :

$$\varepsilon^S = \frac{1}{\beta^S} = \frac{\varepsilon_r(0)\cdot\varepsilon_0}{2\cosh\left(\frac{2}{3}\text{arcsinh}\left(2\frac{E_{dc}}{E_{1/2}}\right)\right)-1} \qquad c^D = c_0^D + M\varepsilon^{S^2}E_{dc}^2$$

$$-h = 2G\varepsilon^S E_{dc}\left(1-\frac{M\varepsilon^{S^2}E_{dc}^2}{c_0^D}\right) \qquad c_{33}^D = c_{33}^E + \frac{e^2}{\varepsilon^S} \qquad h = \frac{e}{\varepsilon^S}$$

On y reconnait l'ensemble des propriétés physiques des matériaux piézoélectriques classiques, mais auxquels viennent se joindre des phénomènes additionnels représentés par les coefficients électrostrictifs $M$ et $G$, et le coefficient d'amortissement électrique $E_{1/2}$.

De tels matériaux pour transducteurs acoustiques ont notamment été décrits dans les articles de Foster, F.S.; Ryan, L.K.; Turnbull, D.H.; "Characterization of lead zirconate titanate ceramics for use in miniature high-frequency (20-80 MHz) transducers", Ultrasonics, Ferroelectrics and Frequency Control, Volume 38, Issue 5, Sept. 1991.

Les premières publications faisant mention de l'emploi de tels matériaux en microélectronique datent de 1999, et notamment : Lobl, H.P.; Klee, M.; Wunnicke, O.; Kiewitt, R.; Dekker, R.; Pelt, E.V.; "Piezo-electric AlN and PZT films for micro-electronic applications", Ultrasonics Symposium, 1999. L'intérêt du PZT (Lead Zirconate Titanate) repose sur ses propriétés piézoélectriques dans des applications radiofréquences.

Le PZT, comme la plupart des matériaux pérovskites, présente une forte permittivité diélectrique, ce qui le destinait directement non pas à des applications exploitant les propriétés piézoélectriques comme les filtres ou les résonateurs, mais à des moyens d'intégration de condensateurs à très haute densité.

Aujourd'hui, sont proposés des composés alternatifs, comme par exemple le Baryum-Strontium-Titanate (BST) depuis quelques années, comme décrit notamment dans la publication : Ivira, B.; Reinhardt, A.; Defay, E.; Aid, M.; "Integration of electrostrictive Ba0.7Sr0.3TiO3 thin films into Bulk Acoustic Wave resonator for RF-frequency tuning under DC bias", Frequency Control Symposium, 19-21 May 2008.

La figure 6 reprise de cette publication montre à cet égard la latitude de variation d'impédance en fonction d'une tension appliquée sur une couche de BST de 580 nm d'épaisseur en présence d'électrodes de Platine de 200 nm. Néanmoins, cette publication repose spécifiquement sur l'analyse de la couche BST réalisée, et non intégrée à une problématique de résonateur.

Il a également été décrit dans la littérature des filtres à base de matériau de type BST à fréquence variable, mais pas utilisés pour assurer une fonction d'ajustement d'impédance dans un circuit d'adaptation d'impédance dans une chaîne comprenant au moins deux composants dont les impédances sont susceptibles de varier. On peut citer à ce titre notamment les références suivantes : PAVEL A TURALCHUK ET AL «Modeling of tunable bulk acoustic resonators and fikters with induced piezoelectric effect in BSTO film in a wide temperature range », NOETH A. ET AL « Tunable thin film bulk acouctic wave resonator based on $Ba_xSr_{1-x}TiO_3$ » et le brevet US 2001/02825.

Dans ce contexte, le demandeur a choisi d'utiliser un modèle dont la robustesse a été démontrée auparavant dans la réalisation de filtres à base de nitrure d'aluminium, afin de prouver l'intérêt de ce type de matériau dans la problématique adressée dans la présente invention. Il s'agit du modèle électro-acoustique de Mason. Ici, le modèle a été adapté aux particularités du matériau BST, notamment afin d'introduire la dépendance au champ électrique.

Les constantes physiques employées sont issues de l'analyse de dispositifs réalisés par le demandeur.

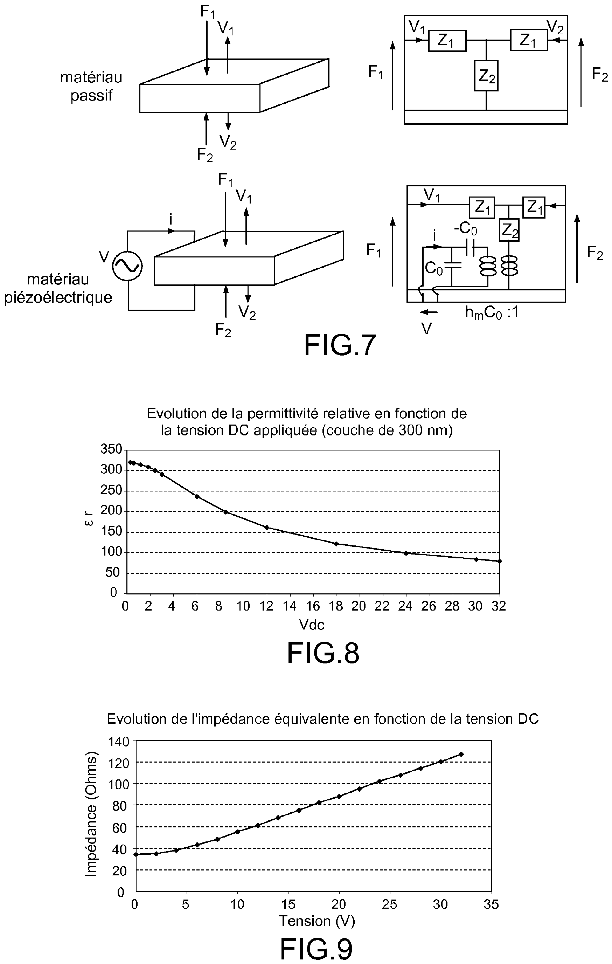

Plus précisément le modèle de Mason est de type électromécanique et permet de traduire les effets de charge des matériaux dans le cas de résonateur à ondes de volume et leurs interactions mécaniques en fonction des vitesses de déplacement de part et d'autre de la couche piézoélectrique. Par analogie électromécanique, les forces sont représentées par des tensions électriques et les vitesses de déplacement sont représentées par des courants électriques. Ainsi, la couche piézoélectrique est modélisée par un bloc à deux ports en tension et un port en courant du fait de ses caractéristiques piézoélectriques et donc de sa capacité à générer une énergie électro-acoustique en présence d'une force à ses interfaces tandis que des autres matériaux passifs, essentiellement les électrodes sont modélisées par des blocs avec des ports essentiellement en tension comme illustré en figure 7.

Plus précisément, le demandeur a mis en évidence les caractéristiques suivantes à partir d'un résonateur de type BAW réalisé avec un matériau de BST, les caractéristiques du résonateur étant constituées par l'empilement de couches suivant :

- Une couche de matériau piézoélectrique : 300nm de BST
- Des électrodes : 100nm de Pt
- Des moyens pour appliquer une tension entre 0 et 32V
- Une surface de : $12\mu$m x $12\mu$m ($50\Omega$ à 8.5V)

Les performances obtenues à 8.5V sont :

- Une fréquence série Fs = 3.404GHz
- Un coefficient de qualité dit série Qs = 157
- Une fréquence parallèle Fp = 3.565GHz
- Un coefficient de qualité dit parallèle Qp = 242
- Un coefficient de couplage $K_t^2$ = 10.65%

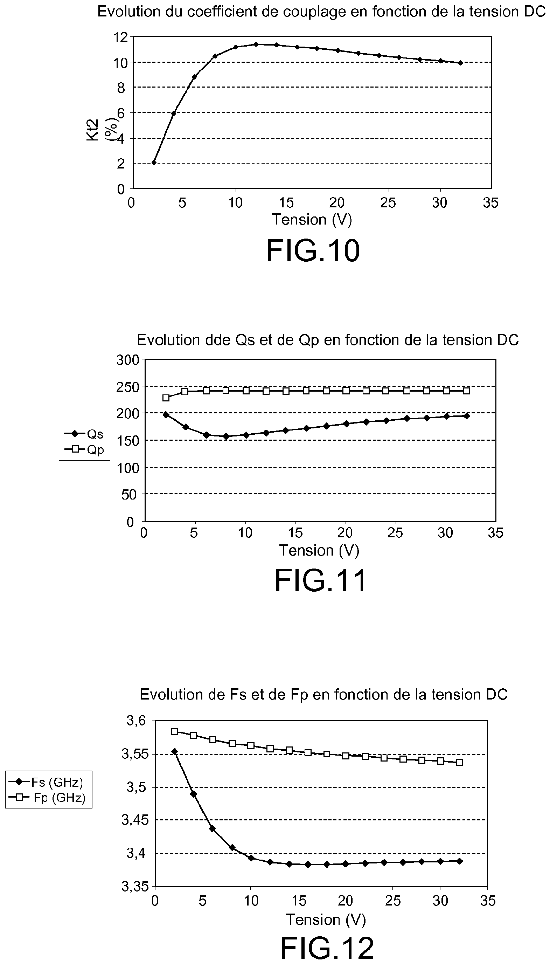

De l'ensemble des figures 8, 9, 10, 11 et 12 il est possible de tirer les éléments d'analyse suivants, mettant en évidence les propriétés d'un tel résonateur. On note l'évolution de l'impédance du résonateur, liée à celle de la permittivité. On constate que le coefficient de couplage présente une évolution très rapide à champ faible, puis présente une variation faible. On repère également la forte dispersion de la résonance série en comparaison avec celle de la résonance parallèle. On note aussi qu'à champ fort, les deux résonances évoluent en sens contraire. C'est de cette analyse mise en face de besoins nouveaux en matière de fonction de filtrage dans l'auto-adaptation, que sont notamment issus, les éléments inventifs décrits dans la présente invention.

Exemple de filtre adaptable en impédance selon l'invention:

Le filtre adaptable en impédance comprend une structure en double lattice et des résonateurs à base de matériau de type pérovskite de BST.

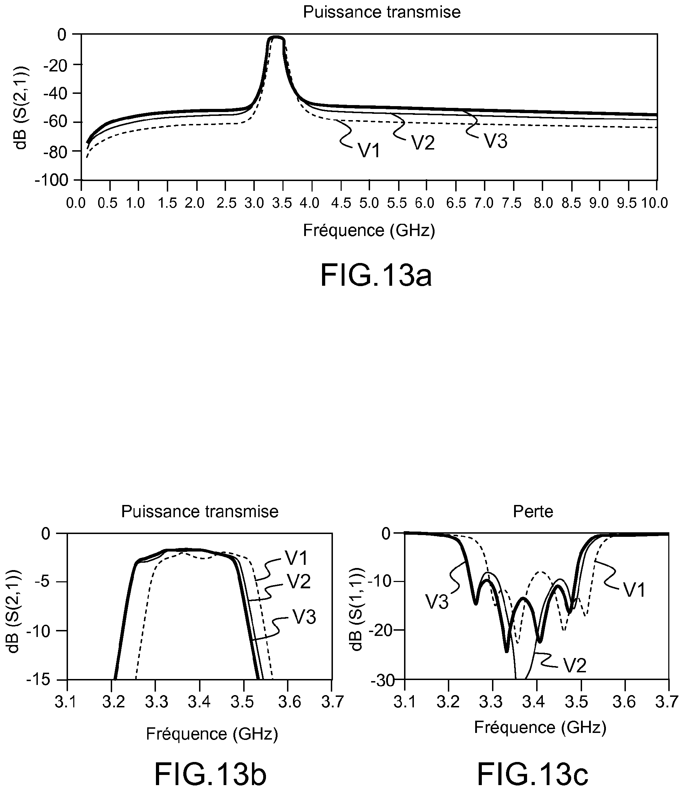

Les figures 13a, 13b et 13c présentent la réponse d'un tel filtre double lattice dont la tension continue appliquée simultanément sur les résonateurs du filtre prend les valeurs V1, V2 et V3. L'impédance caractéristique équivalente du filtre est donnée en conséquence dans le tableau suivant :

| Vdc (V) | V1 = 6V | V2 = 19V | V3 = 32V |
|---|---|---|---|
| Zeq diff ($\Omega$) | 100 | 200 | 300 |

On constate que la fréquence centrale du filtre varie un peu de V1 à V3, et de façon plus significative entre V1 et V2 qu'entre V2 et V3. Ceci est dû au fait que les variations du coefficient de couplage et des fréquences de résonance des résonateurs sont plus fortes à basse tension qu'à haute tension, à l'image des courbes présentées en figures 8 à 12. On constate par ailleurs que l'impédance, elle, varie linéairement sur la même plage de variation en tension.

Dans le présent exemple, la partie réelle de l'impédance caractéristique du filtre varie d'un facteur 3 (de 100 à 300 Ohms) entre V1 et V3. Le filtre présente une transmission en puissance maximum sur une bande comprise entre 3.3GHz et 3.485GHz, soit 185MHz (qu'on peut exprimer également en pourcentage de la fréquence centrale, soit 5.5% à 3.4GHz). En comparaison des 230MHz (soit 6.7% à 3.4GHz) obtenus pour V=V3, on peut potentiellement perdre 20% en largeur de bande. Le coefficient de réflexion, quant à lui, demeure satisfaisant, de l'ordre de -10dB sur la plage d'utilisation.

Il est intéressant de réduire la plage de suivi en impédance, au profit de la largeur de bande exploitable, permettant de s'affranchir des variations fortes à basse tension.

| Vdc (V) | V1 = 13V | V2 = 19V | V3 = 32V |
|---|---|---|---|
| Zeq diff ($\Omega$) | 150 | 200 | 300 |

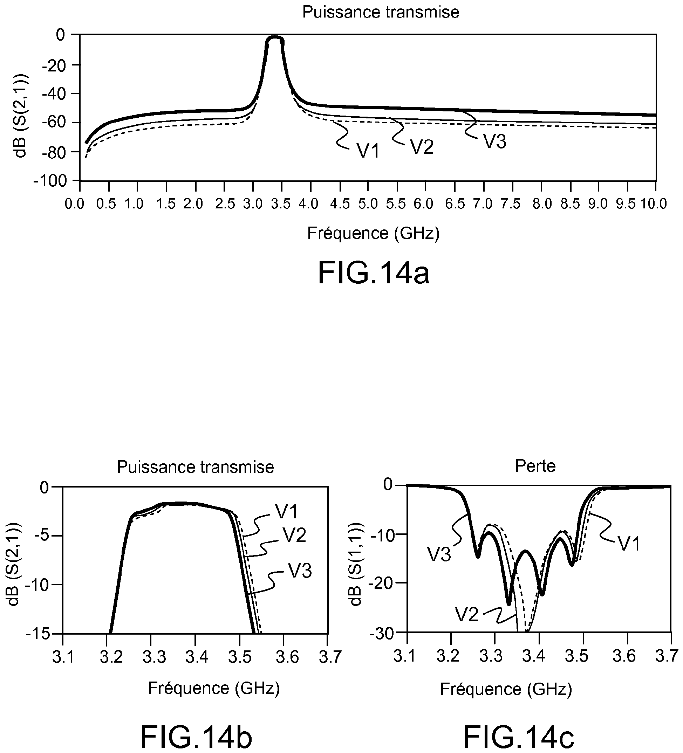

Ainsi, en maintenant le suivi d'impédance entre 150 et 300 Ohms dans cet exemple (tension comprise entre 13V et 32V), la bande varie de seulement 5%. C'est ce qu'illustrent les figures 14a, 14b et 14c pour des tensions V1, V2 et V3 de 13, 19 et 32V.

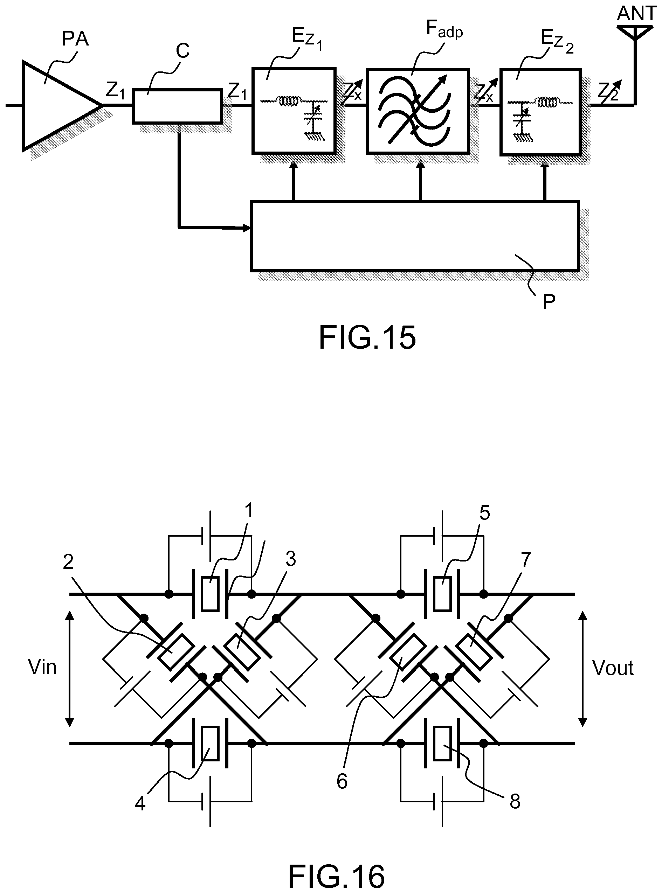

Selon la présente invention, il est ainsi proposé de réaliser un dispositif d'adaptation d'impédance avec un filtre adaptable en impédance et de l'inclure dans une chaîne de transmission telle que celle illustrée en figure 15. Plus précisément cette chaîne d'amplification fonctionnant en dynamique, comprend un amplificateur de puissance PA, un capteur C dont la fonction est de relever une information sur la désadaptation de l'amplificateur, deux éléments supplémentaires d'impédance $E_{Z1}$ et $E_{Z2}$, le filtre adaptable en impédance $F_{adp}$, une antenne et un processeur P ayant pour rôle de piloter les éléments variables. Les éléments d'impédance permettent en combinaison avec le filtre à impédance adaptable de régler l'adaptation d'impédance en corrélation avec l'impédance de l'antenne susceptible de présenter des dispersions.

Plus précisément, le filtre adaptable en impédance est réalisé à partir de résonateurs de type BAW et dans une structure de type « Double Lattice », comprenant huit résonateurs référencés 1, 2, 3, 4, 5, 6, 7 et 8 agencés électriquement quatre à quatre en treillis, comme indiqué sur la figure 16.

Chaque résonateur est piloté électriquement par un générateur de tension continue. Le filtre utilisé dans la présente invention pourrait tout aussi bien fonctionner avec un circuit de type « Ladder » en échelle, ou être de tout autre type comportant un agencement d'au moins deux résonateurs acoustiques, avec possiblement des éléments passifs d'autre nature, comme par exemple des inductances, des capacités ou des lignes de transmission.

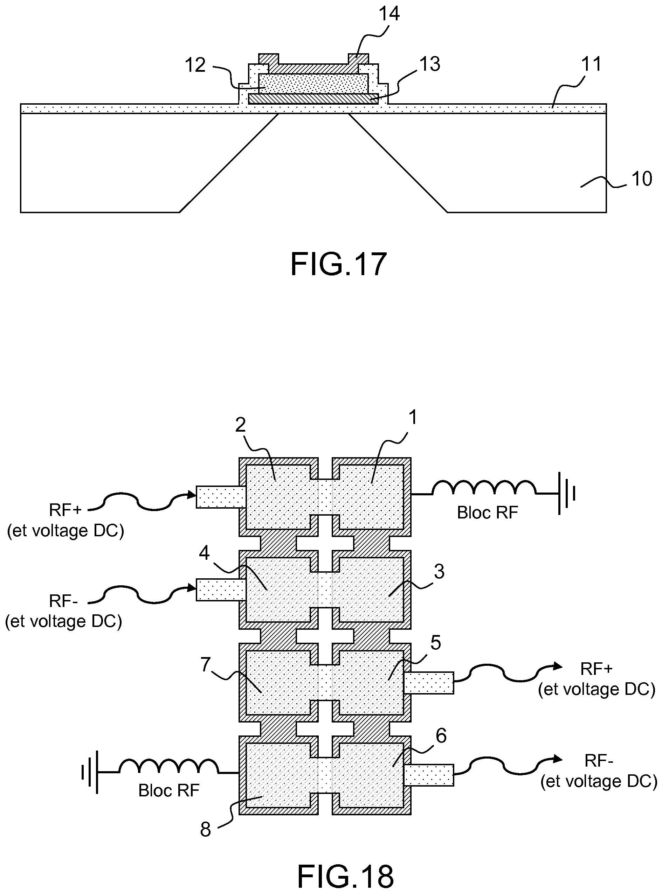

Un mode de réalisation possible pour chaque résonateur est l'empilement de type FBAR. Il s'agit d'un empilement technologique comprenant un substrat 10 évidé en face arrière, une membrane de support 11, et une couche de matériau électrostrictif 12 inséré entre deux électrodes métalliques 13 et 14 comme indiqué sur la figure 17, représentant la coupe transversale d'un tel résonateur.

Selon cet exemple, les électrodes inférieures sont connectées quatre à quatre, et les électrodes supérieures, deux à deux, les résonateurs étant également avec des références possibles 1, 2, 3, 4, 5, 6, 7 et 8 en figure 18. Il est à noter que d'autres combinaisons de résonateurs correspondant au schéma de la figure 16 seraient également possibles.

Toutes les électrodes inférieures sont reliées à la masse DC à travers un dispositif assurant une isolation RF comme illustré en figure 18. Une tension continue identique est ici superposée aux signaux RF en entrée et en sortie du filtre. Selon cet exemple, toutes les tensions appliquées peuvent être identiques pour tous les résonateurs grâce à l'agencement des résonateurs proposé.

**Revendications**

1. Dispositif comprenant en entrée un premier composant (PA) de première impédance de sortie ($Z_1$), en sortie un second composant (ANT) de seconde impédance d'entrée ($Z_2$), un circuit d'adaptation d'impédance entre lesdits premier et second composants **caractérisé en ce que** la première et/ou la deuxième impédance étant variable, ledit circuit d'adaptation d'impédance comprend un filtre à impédance adaptable ($F_{adp}$) aux première et seconde impédances, situé entre lesdits premier et second composants, **caractérisé en ce que** le dispositif comprends au moins deux résonateurs couplés à ondes acoustiques, au moins un des résonateurs comportant un matériau de type pérovskite et des moyens pour appliquer une tension audit résonateur permettant d'en faire varier la permittivité et l'impédance, lesdits moyens pour appliquer une tension étant réglés sur une plage de tension pour laquelle la bande de fréquence dudit filtre à adaptation d'impédance varie de peu, typiquement de quelques pourcents, la variation de l'impédance d'au moins ledit résonateur générant l'adaptation de l'impédance dudit filtre.

2. Dispositif selon la revendication 1, **caractérisé en ce que** chaque résonateur comprend un matériau de type pérovskite.

3. Dispositif selon l'une des revendications 1 ou 2, **caractérisé en ce que** le filtre comporte des résonateurs à ondes de volume.

4. Dispositif selon la revendication 3, **caractérisé en ce que** le filtre comporte des résonateurs à ondes de volume de type FBAR comportant un empilement de couches comprenant au moins une membrane de support et une couche de matériau de type pérovskite.

5. Dispositif selon la revendication 3, **caractérisé en ce que** le filtre comporte des résonateurs à ondes de volume de type SMR comprenant au moins un réflecteur acoustique et une couche de matériau de type pérovskite.

6. Dispositif selon l'une des revendications 1 à 5, **caractérisé en ce que** le matériau de type pérovskite est à base de Baryum-Strontium-Titanate (BST).

7. Dispositif selon l'une des revendications 1 à 6, **caractérisé en ce que** le filtre comporte un ensemble de résonateurs montés en structure échelle et/ou en structure treillis.

8. Dispositif selon l'une des revendications 1 à 7, **caractérisé en ce que** ledit circuit d'adaptation d'impédance comprend en outre d'autres éléments d'impédance.

9. Dispositif selon l'une des revendications 1 à 8, **caractérisé en ce que** le composant à impédance variable est une antenne.

10. Dispositif selon l'une des revendications 1 à 9, **caractérisé en ce que** le composant à impédance variable est un amplificateur.

11. Dispositif selon l'une des revendications 1 à 10, **caractérisé en ce que** le composant à impédance variable est un transistor.

12. Dispositif selon l'une des revendications 1 à 11, **caractérisé en ce qu'**il est inclus dans une chaîne d'émission et/ou de réception radiofréquence dans laquelle le premier composant est un amplificateur (PA), le second composant étant une antenne (ANT).

**Patentansprüche**

1. Vorrichtung, die am Eingang eine erste Komponente (PA) mit einer ersten Ausgangsimpedanz ($Z_1$), am Ausgang eine zweite Komponente (ANT) mit einer zweiten Eingangsimpedanz ($Z_2$) und eine Impedanzanpassungschaltung

zwischen der ersten und der zweiten Komponente umfasst, **dadurch gekennzeichnet, dass**, dadurch bedingt, dass die erste und/oder die zweite Impedanz variabel ist/sind, die Impedanzanpassungsschaltung ein an die erste und die zweite Impedanz anpassungsfähiges Impedanzfilter ($F_{adp}$) umfasst, das sich zwischen der ersten und der zweiten Komponente befindet, **dadurch gekennzeichnet, dass** die Vorrichtung Folgendes umfasst:
wenigstens zwei mit akustischen Wellen gekoppelte Resonatoren, wobei wenigstens einer der Resonatoren ein Material des Perowskit-Typs und Mittel zum Anlegen einer Spannung an den Resonator umfasst, so dass dessen Dielektrizitätskonstante und Impedanz variiert werden können, wobei die Mittel zum Anlegen einer Spannung in einem Spannungsbereich geregelt werden, für den das Frequenzband des Impedanzanpassungsfilters geringfügig, typischerweise um ein paar Prozent variiert, wobei die Variation der Impedanz von wenigstens dem Resonator die Anpassung der Impedanz des Filters erzeugt.

2. Vorrichtung nach Anspruch 1, **dadurch gekennzeichnet, dass** jeder Resonator ein Material des Perowskit-Typs umfasst.

3. Vorrichtung nach Anspruch 1 oder 2, **dadurch gekennzeichnet, dass** das Filter Volumenwellenresonatoren umfasst.

4. Vorrichtung nach Anspruch 3, **dadurch gekennzeichnet, dass** das Filter Volumenwellenresonatoren des FBAR-Typs umfasst, umfassend einen Stapel von Schichten, die wenigstens eine Trägermembran und eine Materialschicht des Perowskit-Typs umfassen.

5. Vorrichtung nach Anspruch 3, **dadurch gekennzeichnet, dass** das Filter Volumenwellenresonatoren des SMR-Typs umfasst, umfassend wenigstens einen akustischen Reflektor und eine Materialschicht des Perowskit-Typs.

6. Vorrichtung nach einem der Ansprüche 1 bis 5, **dadurch gekennzeichnet, dass** das Material des Perowskit-Typs auf Barium-Strontium-Titanat (BST) basiert.

7. Vorrichtung nach einem der Ansprüche 1 bis 6, **dadurch gekennzeichnet, dass** das Filter einen Satz von Resonatoren umfasst, die in Leiterstruktur und/oder in Gitterstruktur montiert sind.

8. Vorrichtung nach einem der Ansprüche 1 bis 7, **dadurch gekennzeichnet, dass** die Impedanzanpassungschaltung ferner weitere Impedanzelemente umfasst.

9. Vorrichtung nach einem der Ansprüche 1 bis 8, **dadurch gekennzeichnet, dass** die Komponente mit variabler Impedanz eine Antenne ist.

10. Vorrichtung nach einem der Ansprüche 1 bis 9, **dadurch gekennzeichnet, dass** die Komponente mit variabler Impedanz ein Verstärker ist.

11. Vorrichtung nach einem der Ansprüche 1 bis 10, **dadurch gekennzeichnet, dass** die Komponente mit variabler Impedanz ein Transistor ist.

12. Vorrichtung nach einem der Ansprüche 1 bis 11, **dadurch gekennzeichnet, dass** sie in einer Radiofrequenzsende- und/oder -empfangskette enthalten ist, in der die erste Komponente ein Verstärker (PA) ist, wobei die zweite Komponente eine Antenne (ANT) ist.

## Claims

1. A device comprising a first component (PA), at the input, having a first output impedance ($Z_1$), a second component (ANT), at the output, having a second input impedance ($Z_2$), an impedance-matching circuit between said first and second components, **characterised in that** the first and/or the second impedance being variable, said impedance-matching circuit comprises a filter ($F_{adp}$) having impedance that can be matched to the first and second impedances, which filter is located between said first and second components, **characterised in that** the device comprises at least two coupled acoustic wave resonators, at least one of the resonators comprising a perovskite type material and means for applying a voltage to said resonator allowing the permittivity and the impedance thereof to be varied, said means for applying a voltage being regulated over a voltage range, for which the frequency band of said impedance-matching filter hardly varies, typically by several percent, the variation of the impedance of at least said resonator generating the impedance matching of said filter.

2. The device as claimed in claim 1, **characterised in that** each resonator comprises a perovskite type material.

3. The device as claimed in claim 1 or 2, **characterised in that** the filter comprises bulk wave resonators.

4. The device as claimed in claim 3, **characterised in that** the filter comprises bulk wave resonators of the FBAR type comprising a stack of layers comprising at least one support membrane and one layer of perovskite type material.

5. The device as claimed in claim 3, **characterised in that** the filter comprises bulk wave resonators of the SMR type comprising at least one acoustic reflector and one layer of perovskite type material.

6. The device as claimed in any one of claims 1 to 5, **characterised in that** the perovskite type material is based on Barium Strontium Titanate (BST).

7. The device as claimed in any one of claims 1 to 6, **characterised in that** the filter comprises a set of resonators mounted as a ladder and/or lattice structure.

8. The device as claimed in any one of claims 1 to 7, **characterised in that** said impedance matching circuit further comprises other impedance elements.

9. The device as claimed in any one of claims 1 to 8, **characterised in that** the variable impedance component is an antenna.

10. The device as claimed in any one of claims 1 to 9, **characterised in that** the variable impedance component is an amplifier.

11. The device as claimed in any one of claims 1 to 10, **characterised in that** the variable impedance component is a transistor.

12. The device as claimed in any one of claims 1 to 11, **characterised in that** it is included in a radiofrequency transmission and/or reception line, in which the first component is an amplifier (PA), the second component being an antenna (ANT).

ANT

PA

CA

FA

Zout    Zc    Zc

**FIG.1**

ANT

PA

CA

FA

Zout    Zx    Zx

**FIG.2**

FIG.3

FIG.4

FIG.5

FIG.6

FIG.7

Evolution de la permittivité relative en fonction de
la tension DC appliquée (couche de 300 nm)

FIG.8

Evolution de l'impédance équivalente en fonction de la tension DC

FIG.9

Evolution du coefficient de couplage en fonction de la tension DC

FIG.10

Evolution dde Qs et de Qp en fonction de la tension DC

FIG.11

Evolution de Fs et de Fp en fonction de la tension DC

FIG.12

Puissance transmise

FIG.13a

Puissance transmise

FIG.13b

Perte

FIG.13c

Puissance transmise

FIG.14a

Puissance transmise

FIG.14b

Perte

FIG.14c

FIG.15

FIG.16

FIG.17

FIG.18

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2037576 A

- US 200102825 B

**Littérature non-brevet citée dans la description**

- **E.L. FIRRAO ; A.J. ANNEMA ; B. NAUTA.** An Automatic Antenna Tuning System using only RF-Signal Amplitudes. IEEE TCAS-II, 2008
- A fast and accurate automatic matching network designed for ultra low power medical applications. **WAI CHAN ; DE FOUCAULD, E. ; VINCENT, P. ; HAMEAU, F. ; MORCHE, D. ; DELAVEAUD, C. ; DAL MOLIN, R. ; PONS, P. ; PIERQUIN, R. ; KERHERVE, E.** Circuits and Systems. IEEE ISCAS, 2009
- **CHAN WAI PO F ; DE FOUCAULD, E. ; VINCENT, P. ; HAMEAU, F. ; KERHERVE, E. ; MOLIN R, D. ; PONS, P. ; PIERQUIN, R.** A 2.4GHz CMOS automatic matching network design for pacemaker applications. *Circuits and Systems and TAISA Conference,* 2009

- **FOSTER, F.S. ; RYAN, L.K. ; TURNBULL, D.H.** Characterization of lead zirconate titanate ceramics for use in miniature high-frequency (20-80 MHz) transducers. *Ultrasonics, Ferroelectrics and Frequency Control,* Septembre 1991, vol. 38 (5
- **LOBL, H.P. ; KLEE, M. ; WUNNICKE, O. ; KIEWITT, R. ; DEKKER, R. ; PELT, E.V.** Piezo-electric AlN and PZT films for micro-electronic applications. *Ultrasonics Symposium,* 1999
- **IVIRA, B. ; REINHARDT, A. ; DEFAY, E. ; AID, M.** Integration of electrostrictive Ba0.7Sr0.3TiO3 thin films into Bulk Acoustic Wave resonator for RF-frequency tuning under DC bias. *Frequency Control Symposium,* 19 Mai 2008